# EUROPEAN PATENT APPLICATION

(11) **EP 3 525 244 A1**
(43) Date of publication of application: **14.08.2019**
(21) Application number: 18305131.7
(22) Date of filing: 08.02.2018
(51) Int. Cl.: H01L 31/0392, H01L 31/068, H01L 31/18, H01L 31/0747

(54) **SILICON LAYER ON SILICON-RICH ALUMINUM LAYER**

(71) Applicant: Université de Strasbourg, 67000 Strasbourg (FR); Centre National de la Recherche Scientifique, 75016 Paris (FR); Sintef AS, 0314 Oslo (NO)
(72) Inventor: BELLANGER, Pierre, 73000 CHAMBÉRY (FR); SLAOUI, Abdelilah, 67370 TRUCHTERSHEIM (FR); ULYASHIN, Alexander, 0777 OSLO (NO)
(74) Representative: Lavoix

(57) **Abstract**

The present invention concerns a process for preparing a material comprising at least one Aluminum (Al) layer bonded to at least one monocrystalline silicon (Si) layer, said process comprising:
(i) putting an Al layer comprising at least 10 % Si in contact with a monocrystalline Si layer, wherein said Si % is expressed in atomic percent (at%);
(ii) bonding said Al layer with said monocrystalline Si layer by thermal treatment;
(iii) obtaining material comprising at least one Al layer bonded to at least one monocrystalline Si layer.

The present invention concerns more particularly the technical field of photovoltaic cells.

## Description

The present invention concerns silicon layer on silicon-rich Aluminum layer, and more particularly concerns their use in the field of photovoltaic and microelectronic.

### Background of the invention

The crystalline silicon wafers obtained by ingot cutting represent about 90% of the photovoltaic market (A. Frey, https://cms.uni-konstanz.de/en/physik/hahn/groups/si-material/). Current used thicknesses are in the range 150-200µm. However, the sawing step of the monocrystalline or multicrystalline ingots has a major disadvantage because the loss of silicon is about 50% and this process has a high cost in terms of energy and consumables. The wire saws use silicon carbide as an abrasive in the slurry and it is difficult to recycle the lost materials from the resulting saw dust-SiC mix. As manufacturers push the limit of wafer thickness, they are resorting to even more expensive methods like diamond wire saws. Many techniques have been developed to try to compete with this process, such as cutting ingots by laser technique, as well as by the growth of ribbon sheets from the melt (RGS, EFG, RST, etc.). However, the balance sheet shows that the product between material quality and throughput remains low to compete with the ingot casting technologies and the different companies have nowadays almost all disappeared.

On the other hand, the exfoliation techniques seem being promising alternatives to the sawing of ingots. They have been developed to allow the detachment of silicon foils between 30 to 100 µm thick starting from a monocrystalline wafer. In fact, the use of silicon wafers with a thickness between 40-60µm also makes it possible to achieve higher conversion efficiencies. The most commonly developed exfoliation techniques are those based on the formation of a defective region within the silicon which serves as a detachment zone. The defective area can be generated by several ways:
- Proton Induced Exfoliation (PIE): SiGen company promises kerf-free watering via an implant-and-cleave process that is still in the early stages of development but could yield wafers with thicknesses down to 20 microns. Their two-step process implants proton ions below the surface of a preshaped brick. A second annealing step causes the silicon to crack off the layer. Exfoliated silicon layers that are 20 microns thick require proton energy of 1.1 MeV to be formed. The firm's prototype implant equipment in use today is in three stages -- an accelerator, a beam line and a vacuum end station. This is an enormous piece of equipment emitting protons and must be enclosed in a thick concrete-walled radiation vault to deal with gamma rays. Once the wafers are cleaved, there is an etch and anneal step to preserve lifetime.
- The formation of a double porous layer on the surface of a silicon wafer followed by the growth of an epitaxial silicon layer as demonstrated by Beamreach Solar (previously Solexel), USA.
However, these two processes suffer of low throughput and high cost associated to the complicated steps, and to the defective area formation process.
- Stress Induced Lift-off (SIL): Other exfoliation techniques have been carried out from deposited layers which induce mechanical stress on the surface of the monocrystalline sample. The detachment is carried out after successive annealing and cooling steps. This process seems to be more attractive in comparison with the others because no fragile layer is created before detachment. The problem arises from the use of liquid nitrogen and/or the surface roughness of the silicon foils which makes it more difficult to switch to industrialization. Silicon sheet solar cells obtained using different layers of stress were tested.

Several problems affect the development of solar cells based on silicon foils (30 to 100µm) and particularly because of the fragility. Indeed, the drawback of using thin silicon foils as absorbing materials for solar cells is their breakability which might hinder their industrialization. Therefore, a mechanical support is necessary during the manufacturing of the cell in order to avoid the risk of breakage. Another limiting factor is the loss of light absorption since a part of the solar radiation is passing through without being converted.

On the other hand, US 7875531 teaches that an Al substrate may be used to create sufficient stress on a Si substrate to detach a Si layer.

Furthermore, US 20140174519 discloses metallic substrates for use in the fabrication of silicon based solar cells.

### Aims of the invention

The invention aims to solve at least one of, and preferably all, the technical problems set forth in the present invention.

In particular, the present invention aims to solve the technical problem of providing a material comprising a monocrystalline silicon (Si) layer and a process for preparing said material at lower costs.

The present invention also aims to solve the technical problem of providing a material comprising a monocrystalline silicon (Si) layer and a process for preparing said material with less complicated steps than known process, such as for example i²-module technology (integrated module interconnected on a glass support) developed by IMEC which comprises the use of a glass substrate as a support during the fabrication of solar cells and the metal contacts are made on the back of silicon foils.

The present invention also aims to solve the technical problem of providing a material comprising a monocrystalline silicon (Si) layer and a process for preparing said material, wherein said monocrystalline silicon (Si) layer is less breakable during the whole process.

The present invention also aims to solve the technical problem of providing a material comprising a monocrystalline silicon (Si) layer and a process for preparing said material, wherein said monocrystalline silicon (Si) layer maybe transferred easily to a receiving substrate.

The present invention also aims to solve the technical problem of providing a material comprising a monocrystalline silicon (Si) layer and a process for preparing said material, wherein said monocrystalline silicon (Si) layer comprises back surface contacts for a photovoltaic cell.

The present invention also aims to solve the technical problem of providing a material comprising a monocrystalline silicon (Si) layer and a process for preparing said material, wherein said monocrystalline silicon (Si) layer has a highest light absorption in the near infrared region.

The present invention also aims to solve the technical problem of providing a material comprising a monocrystalline silicon (Si) layer and a process for preparing said material without deformation thereof during preparation.

The present invention also aims to solve the technical problem of providing a process for preparing a material comprising a monocrystalline silicon (Si) layer, said process enabling exfoliating a monocrystalline silicon (Si) layer from a thicker monocrystalline silicon (Si) substrate.

The present invention also aims to solve the technical problem of providing a process for preparing a material comprising a monocrystalline silicon (Si) layer, said material being suitable for flexible or rigid photovoltaic cells.

### Description of the invention

It was discovered that the invention solves at least one of, and preferably all, the technical problems set forth in the present invention.

The invention relates to a process for preparing a material comprising at least one Aluminum (Al) layer bonded to at least one monocrystalline silicon (Si) layer, said process comprising:
(i) putting an Al layer comprising at least 10 % Si in contact with a monocrystalline Si layer, wherein said Si % is expressed in atomic percent (at%);
(ii) bonding said Al layer with said monocrystalline Si layer by thermal treatment;
(iii) obtaining material comprising at least one Al layer bonded to at least one monocrystalline Si layer.

The invention also relates to a material comprising a monocrystalline Si bonded to an Al layer enriched with at least 10 at% Si. An Al layer comprising at least 10 at% Si is also called a Si-rich Al layer according to the invention.

More particularly, said material is obtainable by a process according to the present invention.

Preferably at least 12 at% Si, and for example at least 15 at% Si.

In one embodiment, said Al layer comprises at least 20 at% Si.

Preferably at least 30 at% Si, and for example at least 40 at% Si.

In one embodiment, said Al layer comprises at least 50 at% Si.

In one embodiment, said Al layer comprises less than 90 at% Si.

In one embodiment, said Al layer comprises less than 85 at% Si.

Advantageously, during thermal annealing process, Aluminum atoms diffuse from the Si-rich Al sheet at least to the back surface of the Si absorbing monocrystalline Si layer and therefore the presence of Al atoms can be detected in the monocrystalline Si layer, for example by SIMS. Advantageously, said aluminum diffusion provides a selective doping of the monocrystalline Si layer. In one embodiment, said Al doping forms a P⁺-type region in the Si P-type layer.

The value of such a Si proportion is still found in the Si-rich Al layer after the step of annealing above, because the substrate material is supersaturated with silicon and, finally, relatively little of the silicon substrate is consumed during annealing

Advantageously, such Si-rich Al layer would reduce wafer manufacturing costs as it avoids notably the use of expansive aluminum paste for contacting and remove one step in the manufacturing process.

Advantageously, Si-rich Al layer is useful as a substrate for one or more silicon layers, in addition to be conductive and highly reflective.

Typically, said Si-rich Al layer is prepared by introducing Si granules in liquid Aluminum. In such embodiment, said Si-rich Al layer comprises grains of Si having a size for example of several micrometers.

Advantageously, such Si-rich Al layer avoids deformation of the monocrystalline Si layer.

In the art, it is typically referred to a Si wafer or Si foil depending on the thickness of the Si layer.

Advantageously, in one embodiment, said monocrystalline Si layer is a silicon foil (Si foil). Typically, in one embodiment, said Si foil has a thickness of less than 150µm. A Si foil is defined as a Si layer having a thickness of less than 150µm.

In one embodiment, said monocrystalline Si layer has a thickness of less than 100µm, and preferably of less than 80µm.

A Si foil has typically a thickness of 10 to 100µm, and preferably of 30 to 100µm.

In one embodiment, said monocrystalline Si layer has a thickness of 30 to 100µm and preferably of 40 to 60µm.

Advantageously, a material according to the invention would increase conversion efficiency in a photovoltaic cell. According to M. A. Green & al, Solar Energy Material & Solar Cells 65 (1-4) (2001), 9-16 a thickness between 40-60µm makes it possible to achieve higher conversion efficiencies;

In one embodiment, at least one dielectric layer is placed in between said Al layer and said monocrystalline Si layer. In one embodiment, said dielectric layer is in contact with the monocrystalline Si layer before said bonding step (ii).

In one embodiment, said dielectric layer is in contact with Si-rich Al sheet before said bonding step (ii).

In one embodiment, said dielectric layer is structured prior to said bonding step (ii).

In one embodiment, said dielectric layer is a structured layer.

In one embodiment, said dielectric layer is a continuous layer.

In one embodiment, said thermal treatment is performed at a temperature above or close to Al melting point but lower than Si melting point, and for example of at least 500°C and for example of 600°C to 900°C. Advantageously, said thermal treatment bonds said Si-rich Al layer to said Si layer.

In one embodiment, said thermal treatment bonds said Si-rich Al layer on the back surface of the silicon layer.

In one embodiment, said thermal treatment is a Rapid Thermal Annealing process (RTA). RTA is typically performed by equipment that heats a single wafer at a time using for example either lamp based heating, a laser, thermal furnace, that a wafer is brought near. In one embodiment, said thermal treatment or RTA is performed at a temperature selected in the range going from 500 to 900°C and for example from 650°C to 700°C.

In one embodiment, said thermal treatment or RTA is performed during a period of less than 2 minutes, typically less than 1 minute and for example during 30 seconds.

Said bonding is preferably performed under inert gas atmosphere or with a flux of inert gas or performed under vacuum.

In one embodiment, the thermal treatment may be combined with a compression bonding step performed at the same time or sequentially. Said compression bonding step is performed for example by applying a pressure on at least one of the layers to bond or help bonding said Si-rich Al layer with said Si layer.

Prior to step (i) of putting said Si-rich Al layer in contact with said Si layer, the process comprises preparing a Si layer.

In one embodiment, said Si layer is a Si foil, typically having a thickness of less than 150µm. Such Si foil may have the thickness of the Si layer in the material as defined in the present invention. In one embodiment, such Si foil may be prepared according to the art.

In one embodiment, said Si layer is a Si wafer, typically having a thickness of about 200 to 2000 µm.

Preferably, a passivation step of the rear surface of said Si layer (Si wafer or Si foil) is performed prior to bonding to said Si-rich Al layer on said rear surface.

Such passivation step is performed according to the art (for example SiN, SiOx, etc.).

In one embodiment, after said passivation step and prior to step (i) of putting said Si-rich Al layer in contact with said Si layer, said process comprises a step of preparing the Si layer to front side metallization, for example by laser ablation of the passivation layer.

In one preferred embodiment, a thin Si layer (typically a Si foil) is prepared from a thicker Si layer (typically a Si wafer).

Advantageously, the present invention allows forming a cleavable layer in a Si layer, preferably in a Si wafer.

In one embodiment, said process comprises forming a fragile zone in the Si layer for cleaving said cleavable layer.

In one embodiment, said fragile zone in the Si layer is formed prior to said bonding step (ii).

Advantageously, said process comprises a step of exfoliating a Si surface layer from the Si layer. Typically, said Si surface layer is exfoliated (or detached) from the monocrystalline Si layer surface. Typically, said Si surface layer forms a Si foil. Accordingly, by such an exfoliation, a Si foil may be exfoliated from a Si wafer.

In one embodiment, said fragile zone is formed by hydrogen implantation. Hydrogen implantation is known by a skilled person. Such hydrogen implantation or equivalent means creates a fragile zone in the Si layer which upon a stress, typically a thermal treatment such as for example RTA, would detach (exfoliate) a thin layer or foil from the thicker Si layer or substrate. Such detachment is generally called in the art "exfoliation" or "hydrogen exfoliation" or even "Si exfoliation" or equivalent terms. Accordingly, said process comprises forming a fragile zone in the Si layer by hydrogen implantation for forming a cleavable layer in said Si layer.

In one embodiment, such hydrogen implantation is performed at low doses and low energy. Typically a low doses is less than 5x10¹⁶ at/cm² and low energy is less than 2 MeV.

Preferably, said Si surface layer comprises said Si-rich Al layer on the side opposite the fragile zone.

Advantageously, according to the invention, in one embodiment, the process of the invention provides simultaneous exfoliation of a Si layer, in particular a Si foil, from a silicon layer (typically forming a substrate) and its bonding on a Si-rich Al layer.

Such exfoliation would reduce silicon cost notably as exfoliation technique reduces silicon loss comparing to silicon ingot wire cutting.

Preferably, said Si-rich Al layer has a thickness of 100 to 2000 µm. In the art, it is often referred to a sheet for a layer having such a thickness.

In one embodiment, said process comprises detaching a Si surface layer from said Si layer performed at said bonding step (ii).

In particular, the process of the present invention enables a fast and costs saving process for preparing a monocrystalline Si layer, and in particular a Si foil, having electrode layer comprising said Si-rich Al layer.

Advantageously, the process of the invention provides an effective bonding of the Si layer, and in particular a Si foil, and the Si-rich Al layer without deformation of said Si-rich Al layer.

More particularly, the process of the invention provides an effective bonding of the Si layer, and in particular a Si foil, and the Si-rich Al layer without deformation of said Si-rich Al layer while creating a back surface contact and/or a back surface field (BSF) region of great interest to thin film based solar cells.

In one embodiment, the Si layer has a back surface forming a back surface field (BSF) region doped with Al of a photovoltaic cell.

In one embodiment, the Si-rich Al layer forms a back surface contact of a photovoltaic cell.

Advantageously, the process of the invention is for the preparation of photovoltaic cells. Advantageously, the process of the invention enables forming in a single step bonding and exfoliation of a Si layer or foil from a Si-rich Al layer, thereby forming a back surface contact for a photovoltaic cell.

In one embodiment, in the process of the invention, the Si layer is a Si foil, wherein said process comprises bonding said Si foil to a Si-rich Al layer forming a substrate for the Si foil, wherein said Si-rich Al layer forms a back contact for said Si foil, notably for preparing a photovoltaic cell.

In one embodiment, in the process of the invention, the Si layer is a Si wafer (substrate), wherein said process comprises (i) forming a fragile zone in the Si layer, preferably close to the surface of the Si layer, (ii) bonding said Si wafer to a Si-rich Al layer and exfoliating a Si foil from said Si wafer, wherein said Si-rich Al layer forms a back contact for said Si foil, notably for preparing a photovoltaic cell.

Advantageously, the Si-rich Al layer and Si layer form together a bilayer.

In one embodiment, the Si-rich Al layer and Si layer form together a monocrystalline P-type Si layer having a P+ doped back surface (doped with Al) and a Si-rich Al back contact for a photovoltaic cell. Typically said, P+ doped back surface provides a Back Surface Field (BSF).

In one embodiment, the Si-rich Al layer and Si layer form together a flexible bilayer.

In one embodiment, said Si layer forms a P-type layer of a photovoltaic cell.

Preferably, a passivation of the rear surface of said Si layer (Si wafer or Si foil) is performed prior to bonding to said Si-rich Al layer on said rear surface.

For preparing a photovoltaic cell, in one embodiment, a junction is prepared on the front surface of said Si layer (opposite the rear surface of said Si layer). Accordingly, the Si-rich Al layer is formed on the rear surface of said junction.

In one embodiment, said junction is a heterojunction.

In one embodiment, said junction is a homojunction.

In one embodiment, said junction comprises an amorphous silicon layer, typically an amorphous N-type Si layer.

In one embodiment, an anti-reflective layer and/or a transparent oxide conducting layer is prepared on the front surface of said junction (opposite the rear surface of said junction).

In one embodiment, front contacts are prepared on said material (on the surface opposite the rear surface comprising the said Si-rich Al layer), thereby forming a photovoltaic cell.

In one embodiment, contacts for a photovoltaic cell are prepared on the front surface of said anti-reflective layer and/or a transparent oxide conducting layer (opposite the rear surface of said anti-reflective layer and/or transparent oxide conducting layer (TCO)). In case the anti-reflective layer is an insulator layer, the metallic layer is in contact with said junction (silicon junction).

Accordingly, the present invention relates to a photovoltaic cell and process for preparing a photovoltaic cell, said photovoltaic cell comprising a material comprising a monocrystalline Si bonded to an Al layer enriched with at least 10 at% Si as defined in the present invention.

The present invention relates to a method for preparing a photovoltaic cell comprising implementing a process as defined in the present invention.

Advantageously, said process is performed at low temperature for preparing said heterojunction and/or transparent conductive oxide (TCO) layer, i.e. typically below 250°C, preferably below 200°C, after said bonding step.

For example, a TCO layer is made of ITO (Indium-Tin-oxygen) or ZnO (zinc oxide).

In one embodiment, said photovoltaic cell is a rigid photovoltaic cell.

Advantageously, said photovoltaic cell is a flexible photovoltaic cell.

Typically all layers are superimposed.

Advantageously, the Si-rich Al layer according to the present invention allows forming a substrate for a Si foil (thin layer of monocrystalline Si), a back surface field, a back contact and a reflective surface for photovoltaic cells.

A material according to the present invention allows using a silicon-rich aluminum layer as a mechanical support to very thin silicon foils during the fabrication of the solar cells. A technical advantage of the invention is avoiding the risk of breakage during the different steps of cell fabrication. Moreover, the use of said silicon-rich aluminum layer allows reducing manufacturing steps as it can be used as conductive and highly reflective layer. It also simplifies the solar cell technology from silicon foil.

One main advantage of the invention is the formation of solar cells based on silicon foils (obtained by different means) bonded on silicon-rich aluminum layer and the formation of solar cells based on silicon foils produced by an innovative method combining in a single step the exfoliation of silicon foil from a monocrystalline substrate and its bonding on a silicon-rich aluminum layer.

On the figures:

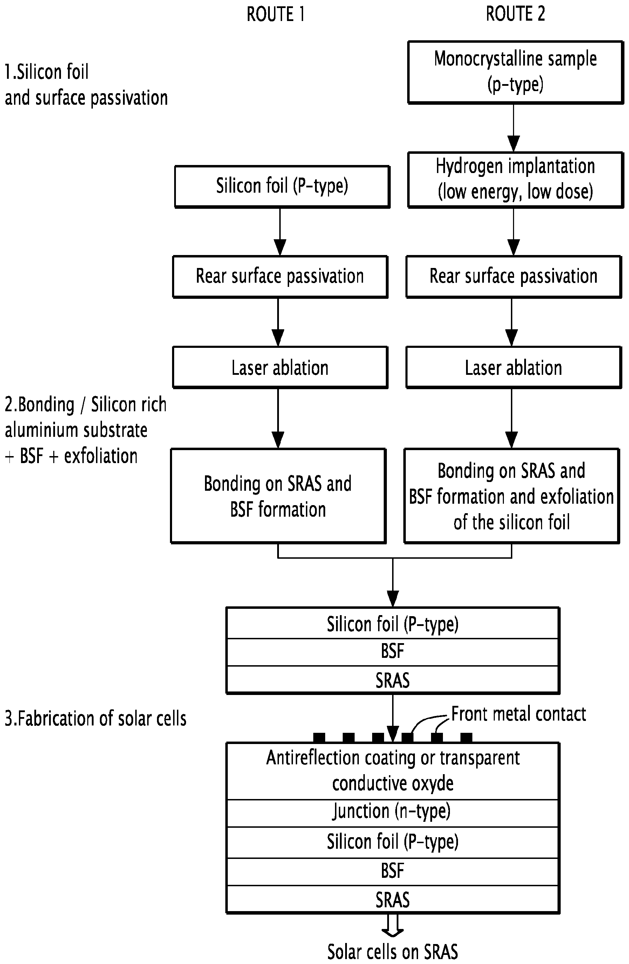

Figure 1 is a block diagram of different embodiments of a process according to the present invention.

### Examples

### Example 1

A Si-rich Al layer (SRAS for Si-rich Al sheet) was fabricated by introducing silicon powders with solar grade purity in the molten aluminum. Thereafter, the melt is carefully stirred to dissolve the silicon. The ingot obtained after cooling was cut by a cold-sawing process in small pieces of 1.5x1.5 cm2 and 2 mm thick. Two different Al layers with concentrations of silicon of either 12 at% or 50 at% were prepared. It is characterized by the presence of crystalline silicon grains with a size of several micrometers. Then solar cells using the Si foil/Si-rich Al layer structure were fabricated.

The following process was performed:
Step 1: Silicon foils (40µm) were made by proton induced exfoliation (PIE) and thermal annealing (energy 1.5 Mev, dose 10¹⁷ at/cm²);
Step 2: Front surface field was realized by Arsenic implantation (energy 30 kev, dose 5x 10¹⁵/cm²);
Step 3: Dopant activation was performed by Rapid Thermal Annealing process (RTA) at 925°C during 30s;
Step 4: A Si-rich Al layer was put in contact with said silicon foil;
Step 5: Bonding and formation of the back surface field (BSF) of the silicon foil was done on Si-rich Al layer by Rapid Thermal Annealing process (RTA) during 30s using temperatures between 650°C and 700°C;
Step 6: Evaporation of the metal contacts (Ti/Pd/Ag) on the front of the silicon foil through a mask.

The photovoltaic performances of the Si foil/SRAS solar cells using the above steps were deduced from the IV characteristics measurements. Conversion efficiencies of 6.5% and 7.5% were obtained from a 40µm foil silicon attached to Si rich Al substrate using a silicon concentration of 12 at% and 50 at% respectively.

Such results on solar cells structures without any process and structure optimizations (No anti-reflective coating and surface passivation have been performed at this stage) are very promising for the fabrication of silicon foils combined with the advantages offered by the silicon rich aluminum substrates (conductive, reflective, stress) and useful for preparing solar cells.

| Substrate | Sticking conditions | Voc (mV) | Jcc (mA/cm²) | FF (%) | η (%) |
|---|---|---|---|---|---|
| C_{Si} = 12% | 650°C, 30s | 534 | 20.5 | 59.5 | 6.7 |
| C_{Si} = 50% | 700°C, 30s | 503 | 20.1 | 74.2 | 7.5 |

### Example 2

A way to prepare solar cell is the following (notably by reference to figure 1, route 1):
- preparing monocrystalline Si foils (P type);
- passivating the back surface of said Si foil (passivating the bottom surface);
- putting a Si-rich Al layer (SRAS) in contact with a monocrystalline Si foil;
- bonding said Si-rich Al layer with said monocrystalline Si foil by thermal treatment, thereby forming a back surface field (BSF) on the bottom face of said Si foil;
- thereby obtaining a bilayer material (stack of layers) having a P-type Si foil and a back surface field bonded to a Si-rich Al layer ;
- forming an amorphous N-type Si heterojunction on the front face of said Si foil;
- forming an anti-reflective layer and/or a TCO layer on the front face of said amorphous N-type Si heterojunction;
- obtaining a silicon solar cell on a Si-rich Al layer, notably by adding appropriate front metallic contacts.

### Example 3

A way to prepare solar cell is the following (notably by reference to figure 1, route 2):
- preparing monocrystalline Si wafer (P type); optionally said Si wafer having a dielectric layer on its back surface;
- implanting Hydrogen for forming a cleavable zone in the Si wafer;
- passivating the back surface of said Si wafer (passivating the bottom surface) of Si wafer;
- putting a Si-rich Al layer (SRAS) in contact with a monocrystalline Si wafer;
- bonding said Si-rich Al layer with said monocrystalline Si wafer by thermal treatment, thereby forming a back surface field on the bottom face of said Si foil and exfoliating a Si foil from said Si wafer at the same process step;
- thereby obtaining a bilayer material having a P-type Si foil and a back surface field bonded to a Si-rich Al layer;
- forming an amorphous N-type Si heterojunction on the front face of said Si foil;
- forming an anti-reflective layer and/or a TCO layer on the front face of said amorphous N-type Si heterojunction;
- obtaining a silicon solar cell on a Si-rich Al layer, notably by adding appropriate front metallic contacts.

## Claims

1. A process for preparing a material comprising at least one Aluminum (Al) layer bonded to at least one monocrystalline silicon (Si) layer, said process comprising:
(i) putting an Al layer comprising at least 10 % Si in contact with a monocrystalline Si layer, wherein said Si % is expressed in atomic percent (at%);
(ii) bonding said Al layer with said monocrystalline Si layer by thermal treatment;
(iii) obtaining material comprising at least one Al layer bonded to at least one monocrystalline Si layer.

2. The process according to claim 1, wherein said Al layer comprises at least 20 at% Si.

3. The process according to any one of claims 1 to 2, wherein at least one dielectric layer is placed in between said Al layer and said monocrystalline Si layer.

4. The process according to claim 3, wherein said dielectric layer is structured prior to said bonding step (ii).

5. The process according to any one of claims 1 to 4, wherein said thermal treatment is performed at a temperature above or close to Al melting point but lower than Si melting point, and for example of at least 500°C and for example of 600°C to 900°C.

6. The process according to any one of claims 1 to 5, wherein said process comprises forming a fragile zone in the Si layer.

7. The process according to claim 6, wherein said fragile zone in the Si layer is formed by hydrogen implantation.

8. The process according to any one of claims 1 to 7, wherein said process comprises detaching a Si surface layer from said Si layer performed at said bonding step (ii).

9. A material comprising a monocrystalline Si bonded to an Al layer enriched with at least 10 at% Si.

10. The material according to claim 9, wherein said material is obtainable by a process according to any one of claims 1 to 8.

11. A photovoltaic cell comprising a material as defined in claim 9 or 10.

12. The photovoltaic cell according to claim 11, wherein said photovoltaic cell is flexible.

13. A method for preparing a photovoltaic cell comprising implementing a process as defined in any one of claims 1 to 8.
